# EUROPÄISCHE PATENTSCHRIFT

(11) **EP 1 625 592 B1**
(45) Veröffentlichungstag und Bekanntmachung des Hinweises auf die Patenterteilung: **11.06.2008**
(21) Anmeldenummer: 04728176.1
(22) Anmeldetag: 19.04.2004
(51) Int. Cl.: G11C 16/34

(54) **VORRICHTUNG UND VERFAHREN ZUM BEHANDELN EINES ZUSTANDS EINES SPEICHERS**
DEVICE AND METHOD FOR TREATING A STATE OF A MEMORY
DISPOSITIF ET PROCEDE POUR TRAITER UN ETAT D'UNE MEMOIRE

(30) Priorität: 20.05.2003 DE 10322723
(43) Veröffentlichungstag der Anmeldung: 15.02.2006
(73) Patentinhaber: Infineon Technologies AG, 81669 München (DE)
(72) Erfinder: FISCHER, Wieland, 80469 München (DE); SAMEC, Christian, A-8043 Graz (AT)
(74) Vertreter: Zinkler, Franz
(86) Internationale Anmeldenummer: PCT/EP2004/004146
(87) Internationale Veröffentlichungsnummer: WO 2004/105042

(56) Entgegenhaltungen:
- DE-A- 10 037 037
- US-A- 5 963 473
- US-A- 6 005 810

## Beschreibung

Die vorliegende Erfindung bezieht sich auf eine Vorrichtung und ein Verfahren zum Behandeln eines aus einem unvollständigen Schreiben oder Löschen von Daten resultierenden Zustands eines Speichers mit in einer Mehrzahl von Seiten organisierten Speicherzellen, wobei der Speicher insbesondere ein UCP-EEPROM (UCP-EEPROM = uniform channel programming electrically erasable read only memory = elektrisch löschbarer programmierbarer Festwertspeicher mit gleichförmiger Kanalprogrammierung) ist.

Elektrisch löschbare programmierbare Festwertspeicher (EEPROMs) werden für zahlreiche Anwendungen verwendet, um Daten nicht-flüchtig bzw. auch nach einem Ausschalten einer Versorgungsleistung zu speichern. Eine Unterart des EEPROMs ist das UCP-EEPROM. Um Chipfläche zu sparen und damit die Herstellungskosten zu verringern, werden in einem UCP-EERPOM unter anderem Bit/Byte-Schalter weggelassen. Der Speicher wird in Seiten bzw. pages organisiert. Eine Seite besteht aus einer Anzahl von Bytes oder Wörtern, wobei ein Wort beispielsweise 32 Bit umfassen kann. Eine Seite besteht beispielsweise aus 64 Bytes. Innerhalb einer Seite können im UCP-Konzept keine einzelnen Bits oder Bytes individuell gelöscht werden, d. h. je nach Definition beispielsweise auf 0 gesetzt werden. Auch das Programmieren einzelner Bits oder Bytes ist nur eingeschränkt möglich. Das Programmieren und Löschen erfolgt vielmehr seitenweise, d. h. alle Bits der Seite werden parallel und gleichzeitig geschrieben oder gelöscht. Dabei wird im folgenden davon ausgegangen, daß ein Bit beim Löschen auf 0 gesetzt wird und beim Programmieren gegebenenfalls auf 1 gezogen wird.

Dem erheblichen Vorteil der Einsparung von Chipfläche steht als Nachteil gegenüber; daß eine gesamte Seite gelöscht und dann neu programmiert werden muß, wenn auch nur ein einziges Bit geändert werden soll. Für eine Veränderung der Seite muß diese spätestens vor Beginn des Löschens bis mindestens nach Abschluß des Schreibens gepuffert werden. Diese Pufferung erfolgt in einem (flüchtigen) RAM-Zellenfeld (RAM = random access memory = Speicher mit wahlfreiem Zugriff) oder ebenfalls in einem (nicht-flüchtigen) EEPROM-Zellenfeld. Die Pufferung in einem EEPROM-Zellenfeld weist den Vorteil auf, daß die gepufferten Daten auch bei einem während des Löschens oder Schreibens auftretenden Ausfall der Versorgungsleistung nicht verloren gehen.

Verbreitet ist eine Architektur, bei der eine Anzahl (beispielsweise 32) von Seiten zu einem Sektor zusammengefaßt ist. Ein Sektor S umfaßt bei diesem Beispiel Seiten P1, ..., P32. Um die Notwendigkeit einer Pufferung einer Seite (was im Falle einer nicht-flüchtigen Pufferung wiederum einem EEPROM-Programmiervorgang entspricht) vor ihrem Löschen zu vermeiden, fügt man eine weitere Seite zum Sektor hinzu, die im folgenden mit P0 bezeichnet wird. Die zusätzliche Seite P0 befindet sich zunächst im gelöschten Zustand. Um eine der Seiten P1, ..., P32 zu ändern, wird ihr Dateninhalt einschließlich der Änderungen in die Seite P0 programmiert. Danach wird die alte Seite gelöscht und die Seite P0, die nun die aktualisierten Daten enthält, in den Speicher abgebildet. Die gelöschte Seite übernimmt nun die Rolle, die ursprünglich die Seite P0 hatte. Die jeweils gelöschte überzählige Seite wird Spare-Seite bzw. Ersatz-Seite bzw. Reserve-Seite genannt.

Bei dem beschriebenen Programmiervorgang zum Ändern einer Seite werden Seiten im Sektor durcheinander gewürfelt, d. h. die Zuordnung physikalischer Seiten zu logischen Seiten ist willkürlich und ändert sich bei jedem Programmiervorgang. Um die physikalischen Seiten zu identifizieren bzw. ihre Zuordnung zu logischen Seiten bzw. zu Speicheradressen innerhalb eines Speicheradreßraumes des Sektors zu gewährleisten, weist jede Seite einige Zusatz-Bits auf, die den sogenannten Map- bzw. Zuordnungs-Block bildet. Dieser Zuordnungs-Block weist bei jeder Seite die Map- bzw. Zuordnungs-Adresse auf. Diese zeigt an, welchen Speicheradressen die physikalische Seite entspricht. Um weiterhin bei dem obigen Zahlenbeispiel zu bleiben, steht im Zuordnungs-Block jeder Seite eine ganze Zahl zwischen 1 und 32 oder, was praktikabler ist, zwischen 0 und 31, und gibt die Position der Seite im Speicherraum bzw. Adreßraum des Sektors an. Innerhalb eines Sektors gibt es also eine gelöschte Seite bzw. Spare-Seite und 32 Daten-Seiten bzw. Seiten mit Dateninhalt.

Betrachtet man die 32 Zuordnungs-Blöcke der 32 Datenseiten, so findet man jede ganze Zahl zwischen 1 und 32 (oder, besser: zwischen 0 und 31) genau einmal, und es steht eindeutig fest, welcher Speicheradresse jede physikalische Seite entspricht. Der Zuordnungs-Block umfaßt nicht-flüchtige Speicherzellen, damit die Zuordnung der physikalischen Seiten zu Speicheradressen auch bei einem reset bzw. Rücksetzvorgang oder einem Stromverlust bzw. einem Ausfall der Leistungsversorgung nicht verloren geht. Der Zuordnungsblock ist beispielsweise in die Menge der EEPROM-Zellen der Seite integriert.

Bei dem beschriebenen UCP-Konzept stört jeder Programmiervorgang einer Seite auch die Seiten, die nicht Ziel des Programmiervorgangs sind, ein wenig. Ein Programmiervorgang wird deshalb auch als Disturb bzw. Störung bezeichnet. Jeder Disturb ändert den analogen Zustand einer Speicherzelle. Nach einer großen Anzahl von Disturbs weist die Speicherzelle dann einen veränderten digitalen Zustand auf. Dies ist gleichbedeutend mit einem Verlust bzw. einer Verfälschung der gespeicherten Information. Um diese Folge einer zu großen Anzahl von Disturbs zu verhindern, wird jede Seite bei ihrem Schreiben mit einem Time-Stamp bzw. Zeitstempel versehen. Der Zeitelle Wert eines Zählers, der auch als Disturb-Zähler bezeichnet wird. Der Zeitstempel wird beispielsweise in oder bei dem Zuordnungs-Block abgelegt. Wenn eine Seite altert, d. h. einer wachsenden Anzahl von Disturbs ausgesetzt ist, ist der Zeitstempel immer weiter von dem aktuellen Wert des Zählers entfernt. Der aktuelle Wert ist wiederum gleich dem Maximum aller 32 vorhandener Zeitstempel. Wenn die Differenz zwischen dem Zeitstempel einer Seite und dem aktuellen Wert des Zählers eine vorbestimmte Schwelle überschreitet, wird die Seite neu programmiert, um zu vermeiden, daß sie zu alt wird.

Ein Verlust von Information bzw. Daten, die in einem EERPOM gespeichert sind, ist aus mehreren Gründen nachteilig. Zum einen ist ein Datenverlust an sich in den meisten Fällen unerwünscht, da er unvorhersehbare und oft schwerwiegende Folgen haben kann. Im Fall eines EEPROMs auf einer Chipkarte kann ein Datenverlust ferner beispielsweise zu einer unerwünschten Freigabe von Funktionen oder Leistungsmerkmalen führen. Ferner ist ein Datenverlust für einen Angriff zur Entschlüsselung kryptographischer Merkmale, beispielsweise einer Chipkarte, nutzbar. Seitens einschlägiger Kreise besteht deshalb ein Interesse an der Herbeiführung eines Datenverlusts eines EEPROMs auf einer Chipkarte.

Eine Möglichkeit zur Herbeiführung eines Datenverlusts besteht darin, wiederholt während eines Programmiervorgangs bzw. während des Schreibens einer neuen Seite und des anschließenden Löschens der alten Seite, die Stromversorgung bzw. die Leistungszufuhr zu unterbrechen. Dieser Eingriff wird auch als Tearing bezeichnet. Ein Tearing kann zwei Probleme hervorrufen.
A. Während des Schreibens der neuen Seite oder während des Löschens der alten Seite fällt die Leistungsversorgung aus. Dies führt dazu, daß eine Seite vorhanden ist, die ungültige Daten enthält, da einige Bits bereits in die richtige Richtung gekippt sind bzw. bereits programmiert sind, während andere noch den ursprünglichen Inhalt aufweisen. Dies ist beispielsweise Mittel eines Error-Correcting-Codes bzw. eines Fehlerkorrekturcodes erkennbar. In der Folge wird die ungültige Seite gelöscht.
B. Das Tearing tritt auf nachdem die neue Seite geschrieben und bevor die alte Seite gelöscht ist bzw. nachdem alle zu 1 zu programmierenden Bits der neuen Seite von 0 nach 1 gekippt sind und bevor die ersten mit dem Wert 1 programmierten Bits der alten Seite von 1 nach 0 kippen. Folglich ist eine Seite doppelt vorhanden bzw. zwei physikalische Seiten weisen die gleiche Zuordnungs-Adresse in ihren Zuordnungs-Blöcken auf. In diesem Fall wird eine der beiden Seiten, bevorzugt die anhand des Zeitstempels als älter identifizierte Seite gelöscht.

Bei einem Tearing oder einem anderen Ausfall der Versorgungsleistung während des Schreibens der neuen Seite erzeugt der Schreibvorgang einen Disturb, der die anderen Seiten stört. Wird nun wie unter A beschrieben die ungültige weil unvollständig geschriebene Seite gelöscht, dann bleibt zwar die alte Seite mit den unveränderten Daten erhalten, der Sektor enthält jedoch keine Seite mit dem dem Schreibvorgang entsprechend inkrementierten Zeitstempel. Die Informationen des Disturbs ist somit zwar in Form einer kleinen, akkumulierbaren Störung der Speicherzellen im Rest des Chips vorhanden. Der einen inkrementierten Disturb-Zählerwert wiedergebende Zeitstempel der unvollständig beschriebenen neuen Seite ist jedoch verloren. Um die Information über die Anzahl der Disturbs in den Sektor einzubringen, muß nachträglich in irgendeine Seite des Sektors ein gegenüber dem Maximum der Zeitstempel der Seiten des Sektors inkrementierter Zeitstempel eingebracht werden. Ein Angreifer könnte aber in diesem Augenblick die Leistungszufuhr erneut abschalten. Dadurch wäre die Information über den Disturb unwiederbringlich verloren. Auf diese Art und Weise könnte ein Angreifer (beliebig) viele Disturbs in einen Sektor einbringen, ohne daß das System diesen detektieren könnte. Die Folge ist ein Datenverlust, der für einen Angriff zur Entschlüsselung von kryptographischen Funktionen verwendet werden kann.

Das US-Patent Nr. 5,963,473 offenbart ein Flash-SpeicherSystem und ein Verfahren zum Überwachen des Störungseffekts auf Speicherzellenblöcke aufgrund von Hochspannungsbedingungen anderer Speicherzellenblöcke. Solche Hochspannungsbedingungen treten aufgrund des Löschens von anderen Löschblöcken im gleichen Decodierblock auf. Jedes Mal, wenn ein Löschblock gelöscht wird, aktualisiert die Steuerung eine Tabelle für den Decodierblock, die den gelöschten Block enthält, in dem eine Einheit einer Störung dem Zählwert für jeden anderen Löschblock in dem Decodierblock hinzugefügt wird, und in dem der Zählwert für den gelöschten Block auf Null zurückgesetzt wird.

Das US-Patent Nr. 6,005,810 offenbart einen Byteprogrammierbaren Flash-Speicher mit Zählern und einem Sekundärspeicher für eine Störungssteuerung während Programmier- und Löschbedingungen. Die Zähler zählen die Anzahl von Programmier/Lösch-Zyklen und vergleichen sie mit empirisch bestimmten Zählergrenzen. Wenn eine solche Grenze überschritten wird, werden die in dem System gespeicherten Daten temporär auf den Sekundärspeicher übertragen, während das Speicherarray aufgefresht wird und die Zähler zurückgesetzt werden.

Die Aufgabe der vorliegenden Erfindung besteht darin, ein Verfahren und eine Vorrichtung zum Behandeln eines aus einem unvollständigen Schreiben oder Löschen von Daten resultierenden Zustands eines Speichers zu schaffen.

Diese Aufgabe wird durch eine Vorrichtung nach Anspruch 1 oder ein Verfahren nach Anspruch 3, 14 oder 15 gelöst.

Die vorliegende Erfindung beruht auf der Idee, einen aus einem unvollständigen Schreiben oder Löschen von Daten resultierenden Zustand eines Speichers bzw. eines Sektors eines Speichers so zu behandeln oder zu reparieren, daß zu keinem Zeitpunkt Information über die Disturbs verloren geht. Dazu werden der Beginn und andere Stationen des Verfahrens, das auch als Tearing-Service bezeichnet wird, durch Nachprogrammieren bereits vorhandener Seiten markiert. Dadurch ist jederzeit und auch nach einem erneuten Tearing feststellbar, daß und an welcher Stelle der Tearing-Service unterbrochen wurde.

Ausgangspunkt des erfindungsgemäßen Tearing-Services ist die Ermittlung einer Seite, die eine Inkonsistenz umfaßt. In dem oben beschriebenen Fall A ist dies eine ungültige Seite bzw. eine Seite mit einer Inkonsistenz zwischen ihrem Dateninhalt und ihrem Fehlerkorrekturcode. In dem oben beschriebenen Fall B ist die inkonsistente Seite eine Seite, die die gleiche logische Adresse in ihrem Zuordnungs-Block aufweist wie eine andere Seite, jedoch einen älteren Zeitstempel als diese. Die Seite, die eine Inkonsistenz aufweist, wird im folgenden mit Pb bezeichnet. Im Fall A wird eine beliebige andere Seite ausgewählt, beispielsweise diejenige mit dem ältesten Zeitstempel, und als Pg bezeichnet. Im Fall B wird die jüngere der beiden Seiten mit der gleichen Zuordnungsadresse als Pg bezeichnet.

Nachfolgend wird die Seite Pb gelöscht. Vor dem Löschen der Seite Pb wird jedoch die Seite Pg markiert. Vorzugsweise wird die Seite Pg nach dem Löschen der Seite Pb ein weiteres Mal markiert. Dann wird in die Seite Pg die Information des zusätzlichen Disturbs eingebracht. Die Information über den Disturb wird in die Seite Pg eingebracht, indem diese nach dem Löschen der Seite Pb mit einem entsprechenden neuen Zeitstempel in die gelöschte Seite Pb kopiert wird. Nach diesem Kopiervorgang wird die alte, zweifach markierte Seite Pg gelöscht.

Ein Vorteil der vorliegenden Erfindung besteht darin, daß ein Sektor auf eine Art und Weise repariert wird, daß zu keinem Zeitpunkt Information über erfolgte Disturbs verloren gehen kann und insbesondere auch durch einen zufälligen oder mutwillig herbeigeführten Ausfall der Leistungsversorgung keine Information über Disturbs verloren gehen kann. Dies gilt selbst bei einem mehrfachen Tearing und sogar bei mehrfachem Tearing während eines Tearing-Services.

Ein weiterer Vorteil der vorliegenden Erfindung besteht darin, daß sie mit dem beschriebenen UCP-Konzept kompatibel ist. Ferner erfordert die vorliegende Erfindung keine Veränderung an der Architektur des Zellenfeldes des Speichers bzw. eines Sektors und seiner Seiten.

Die vorliegende Erfindung ist sowohl als Vorrichtung als auch als Verfahren oder Computerprogramm implementierbar.

Nachfolgend werden bevorzugte Ausführungsbeispiele der vorliegenden Erfindung mit Bezug auf die beiliegenden Figuren näher erläutert. Es zeigen:
- Fig. 1: eine schematische Darstellung eines Speichers gemäß einem bevorzugten Ausführungsbeispiel der vorliegenden Erfindung; und
- Fig. 2A, 2B: schematische Flußdiagramme eines Verfahrens gemäß einem bevorzugten Ausführungsbeispiel der vorliegenden Erfindung.

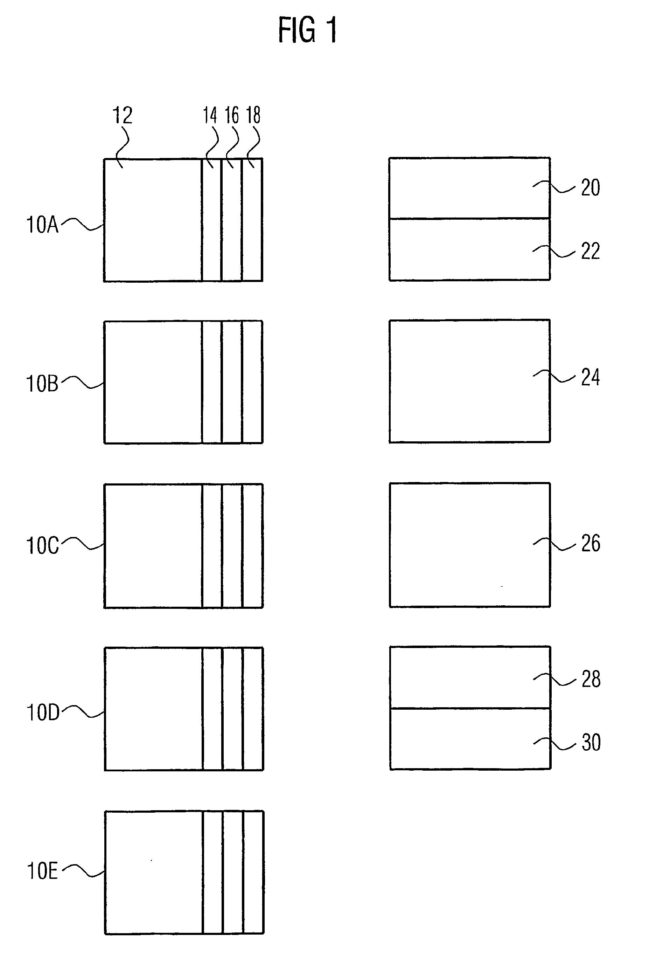

Fig. 1 ist eine schematische Darstellung eines Speichers gemäß einem bevorzugten Ausführungsbeispiel der vorliegenden Erfindung. Der Speicher weist eine Mehrzahl von Seiten 10a, 10b, 10c, 10d, 10e auf, die jeweils gleiche Anzahlen von Speicherzellen zum Speichern von Daten umfassen. Anders ausgedrückt umfaßt der Speicher eine Mehrzahl von Speicherzellen, die in einer Mehrzahl von Seiten 10a, ..., 10e organisiert sind. Jede Seite 10a, ..., 10e umfaßt einen Datenbereich 12 zum Speichern von Daten bzw. Informationen, die von einer außerhalb des Speichers aber möglicherweise auf demselben Chip angeordneten Schaltung, beispielsweise einem Prozessor geschrieben und gelesen werden können. Ferner umfaßt jede Seite 10a, ..., 10e einen Zuordnungsblock 14 zum Speichern einer Zuordnungsadresse, welche die Zuordnung der physikalischen Seiten 10a, ..., 10e zu Speicheradressen des Speichers definiert. Ferner umfaßt jede Seite 10a, ..., 10e einen Markierungsbereich 16, der mindestens eine und bevorzugt mindestens zwei Speicherzellen zum Speichern von Markierungsbits umfaßt. Ferner umfaßt jede Seite 10a, ..., 10e eine Zeitstempelspeicherbereich 18 zum Speichern eines Zeitstempels.

Als ein erstes Beispiel sei angenommen, daß der Speicher wie dargestellt fünf Seiten 10a, ..., 10e umfaßt. Der Datenbereich 12 jeder Seite 10a, ..., 10e umfasse acht Zeilen á acht Bit bzw. einem Byte. Der Zuordnungsblock 14, der Markierungsbereich 16 und der Zeitstempelspeicherbereich 18 sind in einer neunten Zeile angeordnet. In einem regulären Betriebsmodus sind in den Datenbereichen 12 von vier der Seiten 10a, ..., 10e Daten gespeichert. Die Datenbereiche 12 dieser vier Seiten sind Adressen des Adreßbereichs des Sektors zugeordnet. Eine weitere der Seiten 10a, ..., 10e ist leer. Ihr Datenbereich 12 ist keiner der Adressen des Adreßbereichs des Sektors zugeordnet. Die Seiten, die Daten speichern, werden auch als Daten-Seiten bezeichnet, die leere Seite wird als Spare-Seite bzw. Ersatz-Seite bzw. Reserve-Seite bezeichnet. Wie im Folgenden beschrieben wird, sind während des Betriebs des Speichers zu verschiedenen Zeitpunkten verschiedene der fünf physikalischen Seiten die Spare-Seite. Anders ausgedrückt wird bei bestimmten Ereignissen eine Seite, die bis dahin Daten-Seite war, gelöscht und damit zur Spare-Seite, während die bisherige Spare-Seite beschrieben und damit zu einer Datenseite wird.

Jede Seite enthält neben Daten eine Zuordnungsadresse, einen Zeitstempel und Markierungsbits. Die Zuordnungsadresse dient zur eindeutigen Zuordnung des Datenbereichs 12 und seiner Speicherzellen zu Adressen des Adreßbereichs bzw. Adreßraumes des Sektors.

Der Zeitstempel ist eine Zahl, die den Stand eines Disturb-Zählers bzw. Zählers zum Zeitpunkt des Schreibens bzw. Beschreibens der Seite wiedergibt. Der Zähler wird bei jedem Schreibvorgang in dem Sektor erhöht. Die Differenz zwischen dem aktuellen Wert des Zählers und dem Zeitstempel einer Seite gibt an, wie viele Schreibvorgänge im Sektor die Seite seit ihrem letzten Beschreiben erlebt hat. Da, wie eingangs erwähnt, jeder Schreibvorgang im Sektor auch die nicht direkt von dem Schreibvorgang betroffenen Seiten des Sektors stört, muß eine Seite neu geschrieben werden, wenn die Anzahl der Schreibvorgänge seit dem letzten Beschreiben der Seite eine vorbestimmte Schwelle überschreitet.

Während der Speicher mit elektrischer Leistung versorgt wird, wird der Wert des Zählers bevorzugt in einem flüchtigen Speicher gespeichert, und bei jedem Schreibvorgang in dem Sektor inkrementiert. Nach einem Ausfall der Versorgungsleistung ist der flüchtig gespeicherte Wert des Zählers verloren. Nach dem Einschalten der Versorgungsleistung wird deshalb zunächst der höchstwertige Zeitstempel der Seiten des Sektors ermittelt. Dieser höchstwertige Zeitstempel wird dann als Start-Wert in den Zähler geladen.

Eine Seite, die keine Speicherzellen aufweist, die andere Werte als 0 enthalten, ist eindeutig als Spare-Seite identifizierbar, da eine Daten-Seite zumindest einen von 0 verschiedenen Zeitstempel aufweist. Die Spare-Seite muß deshalb nicht anderweitig markiert oder identifiziert werden.

Die Zuordnungsadresse muß zur eindeutigen Adressierung von vier Daten-Seiten zwei Bit umfassen.

Ferner umfasse der Markierungsbereich 16 zwei Speicherzellen zum Speichern von insgesamt zwei Markierungsbits. Der Zuordnungsblock 14 und der Markierungsbereich 16 umfassen somit zusammen fünf Bit und sind damit innerhalb einer Zeile unterzubringen. Ein Speicherbereich zum Speichern des Zeitstempels wird vorzugsweise so groß gewählt, daß er für alle Zählerwerte innerhalb der Lebensdauer des Speichers ausreicht. Ein EEPROM arbeitet beispielsweise typischerweise bis mindestens 10⁴ bis 10⁶ Speichervorgängen pro Seite fehlerfrei. Da höchstens die Hälfte der Speichervorgänge eines Sektors auf eine bestimmte Seite gerichtet sein können, muß der Sektor aus Sicherheitsgründen bei einem Zählerstand von 2·10⁴ bzw. 2·10⁶ deaktiviert werden, um einer Fehlfunktion vorzubeugen. Zum Speichern des Disturb-Zählerwerts oder des Zeitstempels sind demnach 15 bzw. 21 Bit erforderlich.

Eine Seite 10a, ..., 10e umfaßt somit insgesamt elf Zeilen ä acht Bit, wobei acht Zeilen wie oben erwähnt dem Datenbereich 12 zugeordnet sind und in der neunten Zeile der Zuordnungsblock 14 und der Markierungsbereich 16 angeordnet sind. Im Fall einer Lebenserwartung von 10⁴ Speichervorgängen pro Seite enthalten die zehnte und die elfte Zeile den Zeitstempel.

Im Fall einer Lebenserwartung von 10⁶ Speichervorgängen pro Seite enthalten die von dem Zuordnungsblock 14 und dem Markierungsbereich 16 nicht besetzten Bits der neunten Zeile ferner drei Bits des Zeitstempels.

Eine fünfte der fünf Seiten 10a, ..., 10e ist in einem regulären Betriebsmodus leer und dient als Spare-Seite. Wenn Daten innerhalb einer der vier Daten-Seiten aktualisiert bzw. geändert werden sollen, werden die aktualisierten bzw. geänderten Daten, die Zuordnungsadresse der zu ändernden Seite und ein neuer Zeitstempel in die Spare-Seite geschrieben. Anschließend wird die Seite mit dem überholten Dateninhalt gelöscht und damit zur neuen Spare-Seite.

Bei einem weiteren Zahlenbeispiel umfaßt ein Sektor 33 Seiten 10a, ..., 10e, von denen jeweils 32 Seiten durch in ihren Zuordnungsblöcken 14 gespeicherte Zuordnungsadressen dem Adreßbereich des Sektors zugeordnet sind. Eine 33-ste Seite ist in einem regulären Betriebsmodus, d. h. so lange nicht gerade der Dateninhalt einer der Daten-Seiten geändert wird, eine leere Seite bzw. Spare-Seite. Der Datenbereich 12 von jeder der Seiten 10a, ..., 10e umfasse in diesem Zahlenbeispiel 64 Byte in 16 Zeilen á vier Byte. Der Zuordnungsblock 14 umfaßt fünf Bit zum Speichern von Adressen zwischen 0 und 31, durch die jede der 32 Daten-Seiten der 33 Seiten 10a, ..., 10e eindeutig adressierbar ist. Der Markierungsbereich 16 umfaßt wieder zwei Bit zum Speichern von zwei Markierungsbits. Diese insgesamt acht Bits sind vorzugsweise innerhalb einer 17-ten Zeile jeder Seite 10a, ..., 10e angeordnet. Der Zeitstempel wird in weiteren Bits der 17-ten Zeile gespeichert.

Ein Sektor umfaßt neben den Seiten 10a, ..., 10e eine Einrichtung 20 zum Ermitteln einer Erzeugungsinformation aus den Erzeugungsinformationen der Seiten 10a, ..., 10e. Diese Erzeugungsinformation umfaßt vorzugsweise den bereits erwähnten Zeitstempel. Bei jedem Schreiben einer Seite erhält die Seite einen Zeitstempel, der in Form einer Zahl in der Seite gelegt wird. Der Zeitstempel ist der zum Zeitpunkt des Schreibens einer Seite aktuelle Wert eines Zählers, der bei jedem Schreiben einer Seite inkrementiert wird. Nach einem Reset oder einem Einschalten einer Leistungsversorgung ermittelt die Einrichtung 20 zum Ermitteln einer Erzeugungsinformation den höchsten Zeitstempel bzw. den Zeitstempel mit dem größten Wert unter den Zeitstempeln der Seiten 10a, ..., 10e. Dazu liest die Einrichtung 20 die Zeitstempel aller Seiten 10a, ..., 10e oder alternativ die Zeitstempel aller Daten-Seiten 10a, ..., 10e aus und bildet deren Maximum.

Die ermittelte Erzeugungsinformation bzw. der ermittelte maximale Zeitstempel der Seiten 10a, ..., 10e wird an eine Bereitstelleinrichtung 22 zum Bereitstellen einer neuen Erzeugungsinformation basierend auf der ermittelten Erzeugungsinformation übergeben. Die Bereitstelleinrichtung 22 empfängt von der Einrichtung 20 den ermittelten Zeitstempel und inkrementiert diesen. Der inkrementierte Zeitstempel steht daraufhin als neue Erzeugungsinformation für ein nachfolgendes Schreiben einer Seite bereit.

Eine Seitenermittlungseinrichtung 24 ist ausgebildet, um eine der Seiten 10a, ..., 10e zu ermitteln, die eine Inkonsistenz aufweist. Eine Inkonsistenz kann ein Widerspruch zwischen einem Dateninhalt und einem Fehlerkorrekturcode einer Seite sein. Ein solcher Widerspruch rührt von einem vorangehenden unvollständigen Schreiben oder Löschen einer Seite her, bei dem ein Teil der Bits der Seite bereits programmiert bzw. gelöscht wurde, während andere Bits gegenüber einem ursprünglichen Zustand noch unverändert sind.

Bei einem UCP-EEPROM werden beim Schreiben einer Seite alle Bits, die eine logische 1 aufweisen sollen, parallel und gleichzeitig gesetzt, beim Löschen werden alle Bits der Seite parallel und gleichzeitig gelöscht bzw. auf eine logische 0 gesetzt. Tatsächlich handelt es sich beim Schreiben oder Löschen einer Speicherzelle um einen kontinuierlichen Vorgang, bei dem beispielsweise das Potential eines Floating Gates bzw. schwebenden Gates kontinuierlich von einem ersten Zustand, der ein erstes binäres Zeichen darstellt, in einen zweiten Zustand, der ein zweites binäres Zeichen darstellt, übergeführt wird. Aufgrund von Bauelementstreuungen, statistischen Fluktuationen etc. erfolgt der Übergang zwischen einem Zustand, der noch das erste binäre Zeichen darstellt, und einem Zustand, der bereits das zweite binäre Zeichen darstellt, zu einem nicht exakt vorhersagbaren Zeitpunkt. Wenn eine Mehrzahl von Speicherzellen parallel und gleichzeitig programmiert oder gelöscht wird, erfolgt der Übergang zwischen den beiden Zuständen deshalb tatsächlich nicht bei allen Speicherzellen völlig gleichzeitig. Durch Unterbrechung der Leistungsversorgung kann das Speichern oder Löschen zu jedem beliebigen Zeitpunkt unterbrochen werden. Dabei entsteht der beschriebene Zustand, bei dem ein Teil der Speicherzellen bzw. Bits noch einen alten Wert aufweisen, während ein anderer Teil der Bits bereits den neuen Wert aufweist.

Eine weitere Inkonsistenz einer Seite, die durch die Seitenermittlungseinrichtung 24 erkannt bzw. erfaßt wird, ist eine Übereinstimmung von Zuordnungsadressen zweier Seiten. Diejenige der beiden Seiten mit der gleichen Zuordnungsadresse und dem älteren bzw. kleineren Zeitstempel wird als inkonsistent ermittelt. Ein solcher Zustand eines Sektors mit zwei Seiten mit gleichen Zuordnungsadressen kann beispielsweise entstehen, wenn zu einem späten Zeitpunkt ein Schreiben einer Seite mit aktualisiertem Dateninhalt oder zu einem frühen Zeitpunkt eines Löschens einer Seite mit überholtem Dateninhalt die Leistungsversorgung ausfällt oder abgeschaltet wird. In diesem Fall ist es auch möglich, daß zwei Seiten die gleiche Zuordnungsadresse aufweisen, jedoch der Inhalt einer der beiden Seiten im Widerspruch zum Fehlerkorrekturcode der Seite steht. Die Seitenermittlungseinrichtung ist vorzugsweise so ausgebildet, daß sie in diesem Fall diejenige Seite als inkonsistent ermittelt, deren Inhalt im Widerspruch zu ihrem Fehlerkorrekturcode steht, unabhängig davon, ob die Seite den jüngeren oder den älteren Zeitstempel trägt.

Eine Auswahleinrichtung 26 ist ausgebildet, um eine weitere der Seiten 10a, ..., 10e auszuwählen. Im Fall zweier Seiten mit gleicher Zuordnungsadresse wird vorzugsweise die nicht-inkonsistente der beiden Seiten ausgewählt. In anderen Fällen wird eine beliebige andere Seite ausgewählt. Vorzugsweise ist die Auswahleinrichtung 26 so ausgebildet, daß sie in diesem Fall die älteste Seite 10a, ..., 10e bzw. die Seite 10a, ..., 10e mit dem ältesten Zeitstempel auswählt.

Die Auswahleinrichtung 26 ist ferner vorzugsweise ausgebildet, um die ausgewählte Seite durch Setzen eines ersten Markierungsbits zu markieren.

Eine Leseeinrichtung 28 ist ausgebildet, um den Inhalt einer Seite 10a, ..., 10e zu lesen und in einem flüchtigen Speicher abzulegen. Dieses Lesen und Ablegen erfolgt vorzugsweise parallel und simultan für alle Bits der Seite 10a, ..., 10e über eine entsprechende Anzahl paralleler Bitleitungen. Dabei wird vorzugsweise sowohl der Inhalt des Datenbereichs 12 als auch der Inhalt des Zuordnungsblocks 14 aus der Seite 10a, ..., 10e in den Zwischenspeicher kopiert.

Eine Schreibeinrichtung 30 ist ausgebildet, um Daten aus dem Zwischenspeicher in eine der Seiten 10a, ..., 10e zu schreiben bzw. zu kopieren. Die Schreibeinrichtung 30 und die Leseeinrichtung 28 greifen somit auf den gleichen Zwischenspeicher zu. Vorzugsweise werden alle Bits einer Seite 10a, ..., 10e gleichzeitig geschrieben, d. h. sowohl Daten des Datenbereichs 12 als auch die Zuordnungsadresse im Zuordnungsblock 14, Markierungsbits im Markierungsbereich 16 und ein Zeitstempel.

Die Einrichtung 20, die Bereitstelleinrichtung 22, die Seitenermittlungseinrichtung 24, die Auswahleinrichtung 26, die Leseeinrichtung 28 und die Schreibeinrichtung 30 sind entweder fest einem Sektor zugeordnet und damit innerhalb eines Speicherbausteins entsprechend der Anzahl der Sektoren mehrfach vorhanden. Alternativ können sie umschaltbar einem von mehreren oder einem von allen Sektoren eines Speicherbausteins zugeordnet werden.

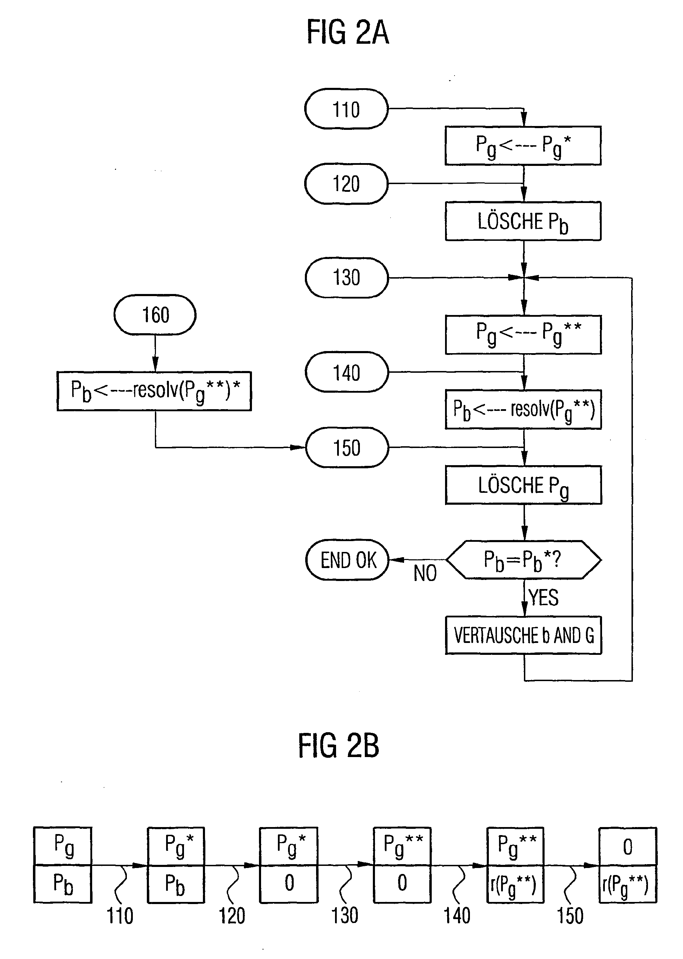

Nachfolgend wird mit Bezug auf die Fig. 2A die Funktion des oben anhand der Fig. 1 dargestellten erfindungsgemäßen Speichers näher erläutert. Die Wirkungen der dargestellten Schritte auf die beiden betroffenen Seiten sind in Fig. 2B dargestellt.

Nach jedem Einschalten einer Versorgungsleistung liest die Einrichtung 20 die Zeitstempel aller Seiten 10a, ..., 10e und ermittelt daraus den jüngsten Zeitstempel bzw. den Zeitstempel mit dem höchsten Zahlenwert. Alternativ wird nicht der jüngste Zeitstempel ermittelt, sondern der zweitjüngste oder ein beliebiger anderer Zeitstempel. Vorzugsweise wird jedoch nicht die Erzeugungsinformation bzw. der Zeitstempel ermittelt, die bzw. der auf den ältesten Programmierzeitpunkt der Seiten 10a, ..., 10e hinweist.

Ferner stellt nach jedem Einschalten gleichzeitig, vor oder nach dem Ermitteln des jüngsten Zeitstempels die Seitenermittlungseinrichtung 24 fest, ob eine der Seiten 10a, ..., 10e eine Inkonsistenz aufweist bzw. ermittelt gegebenenfalls die inkonsistente Seite. Eine inkonsistente Seite ist dabei, wie oben erwähnt, eine Seite mit einem Widerspruch zwischen ihrem Inhalt und ihrem Fehlerkorrekturcode oder eine ältere von zwei Seiten mit gleicher Markierungsadresse.

Eine weitere Seite wird aus den Seiten 10a, ..., 10e ausgewählt, und zwar im Falle des Vorliegens zweier Seiten mit der gleichen Markierungsadresse die nicht-inkonsistente Seite, und andernfalls eine beliebige Seite 10a, ..., 10e, die nicht die inkonsistente Seite ist, und vorzugsweise die älteste Seite 10a, ..., 10e.

Die ermittelte Seite, die eine Inkonsistenz umfaßt, wird im folgenden mit P_{b} bezeichnet, die weitere bzw. ausgewählte Seite wird mit P_{g} bezeichnet.

In einem Schritt 110 wird die weitere Seite P_{g} durch Setzen eines Markierungsbits markiert. Als Markierungsbit wird vorzugsweise ein Bit des Markierungsbereichs oder ein sonst ungenutztes Bit aus dem Zuordnungsblock 14 oder ein anderes bisher nicht genutztes Bit der Seite P_{g} verwendet, das im Normalbetrieb immer im gelöschten Zustand ist bzw. den Wert 0 aufweist und nur bei dem hier beschriebenen Tearing-Service zum Einsatz kommt. Dieses Markierungsbit wird nachprogrammiert und damit auf den Wert 1 bezogen bzw. gesetzt. Alle anderen Bits der Seite bleiben gleich. Das gesetzte Markierungsbit wird auch als Tearing-Flag (TF1) bezeichnet. Die durch das Tearing-Flag TF1 markierte Seite wird mit P_{g}* bezeichnet.

Diese Aktion wird durch das UCP-Konzept zugelassen. Insbesondere kann auch bei einem UCP-EEPROM ein einzelnes Bit auf den Wert 1 gesetzt werden. Dazu wird eine Maske verwendet, die an der Stelle des zu setzenden Bits eine 1 und an allen anderen Stellen je eine 0 aufweist. Alternativ wird als Maske ein Abbild der weiteren Seite verwendet, wobei jedoch das Markierungsbit gesetzt ist. Diese Maske wird dann in die zu markierende weitere Seite kopiert. Dabei bewirkt eine 0 der Maske unabhängig davon, ob das entsprechende Bit der Seite vorher eine 0 oder eine 1 enthielt, keine Veränderung des entsprechenden Bits der Seite. Eine 1 der Maske bewirkt ein Setzen des entsprechenden Bits der Seite.

Anschließend wird in einem Schritt 120 die ermittelte bzw. inkonsistente Seite P_{b} gelöscht.

Während herkömmlich ein Tearing oder ein andersartiger Ausfall der Versorgungsleistung nach dem Löschen der inkonsistenten Seite P_{b} zur Folge gehabt hätte, daß die Information über einen unvollständigen Schreibvorgang, aufgrund dessen der beschriebene Tearing-Service durchgeführt werden muß, verloren wäre, signalisiert nun das gesetzte Markierungsbit bzw. Tearing-Flag TF1, daß der Sektor sich in einem Tearing-Service befand. Erfindungsgemäße Verfahrensschritte, durch die der Tearing-Service nach einem erneuten Einschalten der Versorgungsleistung dann fortgesetzt wird, werden weiter unten näher erläutert.

Nach dem Löschen der inkonsistenten Seite P_{b} wird die markierte Seite P_{g}* in einem Schritt 130 durch Setzen eines weiteren Markierungsbit ein weiteres Mal markiert. Als weiteres Markierungsbit wird ein weiteres ungenutztes Bit ähnlich dem Tearing-Flag TF1 verwendet. Dieses weitere Markierungsbit wird auch als weiteres Tearing-Flag TF2 bezeichnet. Auch das weitere Markierungsbit ist im Normalbetrieb gelöscht und wird nur während des Tearing-Services nach dem Löschen 120 der inkonsistenten Seite P_{b} gesetzt. Die durch das Markierungsbit bzw. Tearing-Flag TF1 und das weitere Markierungsbit bzw. weitere Tearing-Flag TF2 markierte Seite wird mit P_{g}** bezeichnet.

In einem nächsten Verfahrensschritt 140 wird die zweifach markierte Seite P_{g}** in die gelöschte Seite, d. h. in die alte Seite P_{b} kopiert. Dabei werden der Inhalt des Datenbereichs 12 und des Zuordnungsblocks 14 kopiert, nicht jedoch die Markierungsbits im Markierungsbereich 16. Ferner wird im Schritt 140 gleichzeitig der durch die Bereitstelleinrichtung 22 bereitgestellte inkrementierte Zeitstempel in die alte Seite P_{b} geschrieben. Die zweifach markierte Seite P_{g}** mit dem inkrementierten Zeitstempel wird als Resolvente resolv(P_{g}**) bezeichnet.

Der Schritt 140 des Kopierens erfolgt vorzugsweise durch Lesen und Ablegen des Inhalts der zweifach markierten Seite P_{g}** in einem (flüchtigen) Zwischenspeicher und anschließendes Schreiben des Inhalts der zweifach markierten Seite P_{g}** aus dem Zwischenspeicher in die alte Seite P_{b}. Das Löschen der Markierungsbits und das Einbringen eines neuen Zeitstempels erfolgen ohne weiteres durch Manipulieren des Zwischenspeichers nach dem Lesen und vor dem Schreiben.

Durch den inkrementierten Zeitstempel ist nunmehr die Information über die durch das Schreiben hervorgerufene Störung in den Sektor eingebracht.

In einem Schritt 150 wird nun die zweifach markierte Seite P_{g} gelöscht. Damit wird eine neue Spare-Seite hergestellt, und der Sektor ist wieder in einem gültigen Zustand.

Der Tearing-Service ist nach dem Löschen der zweifach markierten Seite P_{g}** abgeschlossen. Im Falle eines UCP-EEPROMs weist der Tearing-Service vorzugsweise die Schritte 120, 150 des Löschens auf, da beim Programmieren einer Seite Bits bzw. Speicherzellen nur gesetzt bzw. von 0 auf 1 gezogen jedoch nicht gelöscht bzw. von 1 auf 0 zurückgesetzt werden können. Im Falle eines anderen Speichertyps, der beim Programmieren auch ein Rücksetzen eines Bits bzw. des Werts einer Speicherzelle von 1 auf 0 zuläßt, werden die Schritte 120 des Löschens der inkonsistenten Seite P_{b}, 130 des weiteren Markierens und 150 des Löschens der zweifach markierten Seite P_{g}** vorzugsweise weggelassen bzw. übersprungen.

Wenn während des Schritts 120 des Löschens der inkonsistenten Seite P_{b} die Versorgungsleistung ausfällt, ist dies nach einem erneuten Einschalten der Versorgungsleistung daran erkennbar, daß der Sektor eine markierte Seite P_{g}* aufweist. Der erfindungsgemäße Speicher setzt in diesem Fall einfach den Tearing-Service fort. Zunächst wird wieder diejenige Erzeugungsinformation der Erzeugungsinformationen der Seiten 10a, ..., 10e ermittelt, die auf den jüngsten, zweitjüngsten oder auch einen anderen Programmierzeitpunkt hinweist. Ferner wird diejenige Seite P_{b} ermittelt, die eine Inkonsistenz umfaßt. Anschließend wird der Tearing-Service ab dem Schritt 120 des Löschens der inkonsistenten Seite P_{b} wie oben beschrieben fortgesetzt.

Das in Fig. 2A dargestellte Flußdiagramm weist neben den oben beschriebenen Verfahrensschritten weitere Verfahrensschritte auf, die durchgeführt werden, wenn der Tearing-Service während des Schritts 140 des Kopierens oder zu Beginn des Schritts 150 des Löschens erneut unterbrochen wird (Tearing während des Tearing-Services). Wenn der Schritt 150 des Löschens zu einem späten Zeitpunkt unterbrochen wird, zu dem bereits ein Teil der Speicherzellen bzw. Bits der zweifach markierten Seite P_{g}** gelöscht ist und deshalb ein Widerspruch zwischen dem Inhalt der Seite und ihrem Fehlerkorrekturcode besteht, so kann das Verfahren nach einem Wiedereinschalten der Versorgungsleistung einfach durch Fortsetzen des Löschens der zweifach markierten Seite P_{g}** abgeschlossen werden, sofern die beiden Markierungsbits noch gesetzt sind. Andernfalls wird die unvollständig gelöschte, ehemals zweifach markierte Seite ein erneutes Durchführen eines vollständigen Tearing-Services nach einem der oben beschriebenen Verfahren auslösen.

Wenn nach dem Wiedereinschalten der Versorgungsleistung eine zweifach markierte Seite P_{g}** ermittelt wird, wird das Verfahren wie folgt fortgesetzt. Vor oder nach dem Ermitteln der zweifach markierten Seite wird wie bei den vorangehend beschriebenen Verfahren vorzugsweise diejenige Erzeugungsinformation der Erzeugungsinformationen der Seiten 10a, ..., 10e ermittelt, die vorzugsweise auf den jüngsten Programmierzeitpunkt der Seiten 10a, ..., 10e hinweist. Zunächst wird nun die Resolvente resolv(P_{g}**) zu Ende programmiert, d. h. die zweifach markierte Seite P_{g}** wird nochmals in die Seite P_{g} kopiert, wobei wie oben beschrieben zunächst der Inhalt der zweifach markierten Seite P_{g}** in einen Zwischenspeicher gelesen von dort in die Seite P_{b} geschrieben wird. Dabei werden vorzugsweise durch Manipulieren des Inhalts des Zwischenspeichers das weitere Markierungsbit bzw. das Tearing-Flag TF2 gelöscht und ein neuer Zeitstempel eingefügt. Der neue Zeitstempel basiert auf dem nach dem Einschalten der Versorgungsleistung ermittelten jüngsten Zeitstempel der Seiten 10a, ..., 10h bzw. wird aus diesem durch Inkrementieren gewonnen.

Anschließend wird im Schritt 150 die zweifach markierte Seite P_{g}** gelöscht. Danach wird überprüft, ob die Seite P_{b} ein gesetztes Markierungsbit TF1 aufweist (P_{b} = P_{g}* ?). Am Ende der oben beschriebenen regulären und ungestörten Tearing-Services ist dies nicht der Fall. Der Tearing-Service wird deshalb wie oben beschrieben beendet.

Wenn der Tearing-Service jedoch mit dem Zuendeprogrammieren 160 der Resolvente wieder aufgenommen wurde, ist die Seite P_{b} einfach markiert (P_{b} = P_{g}*). Daraufhin werden die Schritte 130 des Markierens 140 des Kopierens und 150 des Löschens für vertauschte Seiten P_{b}, P_{g} wiederholt. Bei diesem erneuten Wiederholen wird wiederum der Zeitstempel inkrementiert, um die Information über den Disturb der Speicherseiten in den Sektor einzubringen. Im schlimmsten Fall kann ein Angreifer somit eine unendliche Schleife erzwingen. Dies ist aber kein Problem, da sämtliche Disturbs gezählt werden.

Die obigen Ausführungsbeispiele können in zahlreichen Punkten variiert werden. Beispielsweise kann ein Zeitstempel bzw. ein Disturb-Counter verwendet werden, der bei jedem Schreibvorgang inkrementiert oder aber bei jedem Schreibvorgang dekrementiert wird. Ferner wurde bei den obigen Ausführungsbeispielen davon ausgegangen, daß beim Löschen von Bits bzw. Speicherzellen diese von 1 auf 0 gesetzt und beim Speichern gegebenenfalls von 0 auf 1 gesetzt werden. Eine umgekehrte Zuordnung, bei der gelöschte Speicherzellen den Wert 1 aufweisen und beim Programmieren Speicherzellen gegebenenfalls auf den Wert 0 gesetzt werden, ist hinsichtlich der vorliegenden Erfindung gleichwertig.

Der Zuordnungsblock 14, der Markierungsbereich 16 und der Zeitstempelspeicherbereich 18 sind vorzugsweise wie beschrieben in die jeweilige Seite und ihre Architektur integriert. Alternativ ist der Zuordnungsblock 14 oder der Markierungsbereich 16 oder der Zeitstempelspeicherbereich 18 der Seite zugeordnet jedoch von deren Speicherzellen räumlich getrennt angeordnet oder auch zentral für alle Seiten an einem Ort des Sektors zusammengefaßt.

Die vorliegende Erfindung ist nicht nur auf UCP-EEPROMs, sondern auch auf andere EEPROMs oder Speicher anderer Typen vorteilhaft anwendbar.

Die vorliegende Erfindung ist sowohl in Form eines Verfahrens als auch in Form einer Vorrichtung oder eines Computerprogramms implementierbar. Das erfindungsgemäße Verfahren ist sowohl durch oder mittels der oben anhand der Fig. 1 dargestellten Vorrichtung als auch durch eine andere Vorrichtung oder einen Computer ausführbar, wenn ein Computerprogramm mit Programmcode zur Durchführung des erfindungsgemäßen Verfahrens auf dem Computer abläuft.

### Bezugszeichenliste

- 10a, ... 10e: Seite
- 12: Datenbereich
- 14: Zuordnungsblock
- 16: Markierungsbereich
- 18: Zeitstempelspeicherbereich
- 20: Einrichtung zum Ermitteln
- 22: Bereitstelleinrichtung
- 24: Seitenermittlungseinrichtung
- 26: Auswahleinrichtung
- 28: Leseeinrichtung
- 30: Schreibeinrichtung
- 110: Markieren
- 120: Löschen
- 130: Markieren
- 140: Kopieren
- 150: Löschen
- 160: Kopieren

## Patentansprüche

1. Vorrichtung zum Behandeln eines aus einem unvollständigen Schreiben oder Löschen von Daten resultierenden Zustands eines Speichers mit in einer Mehrzahl von Seiten (10a, ..., 10e), denen jeweils eine Erzeugungsinformation zugeordnet ist, die auf einen Programmierzeitpunkt der Seite hinweist, organisierten Speicherzellen, mit:
einer Einrichtung (20) zum Ermitteln einer Erzeugungsinformation aus den Erzeugungsinformationen der Mehrzahl von Seiten (10a, ..., 10e), um eine ermittelte Erzeugungsinformation zu erhalten, wobei die ermittelte Erzeugungsinformation auf einen Programmierzeitpunkt der Mehrzahl von Seiten (10a, ..., 10e) hinweist, der nicht der älteste Programmierzeitpunkt der Programmierzeitpunkte der Mehrzahl von Seiten ist;
einer Seitenermittlungseinrichtung (24) zum Ermitteln einer Seite (P_{b}) aus der Mehrzahl von Seiten (10a, ..., 10e), die eine Inkonsistenz aufgrund eines unvollständigen Schreibens oder Löschens von Daten umfaßt, um eine ermittelte Seite (P_{b}) zu erhalten;
einer Auswahleinrichtung (26) zum Auswählen einer weiteren Seite (P_{g}) aus der Mehrzahl von Seiten (10a, ..., 10e), um eine ausgewählte Seite (P_{g}) zu erhalten;
einer Markiereinrichtung (30) zum Markieren der ausgewählten Seite (P_{g}), um eine markierte Seite (P_{g}*) zu erhalten;
einer Bereitstelleinrichtung (22) zum Bereitstellen von neuer Erzeugungsinformation basierend auf der ermittelten Erzeugungsinformation;
einer Leseeinrichtung (28) zum Lesen von Daten aus der markierten Seite (P_{g}*); und
einer Schreibeinrichtung (30) zum Schreiben der aus der markierten Seite (10a, ..., 10e) gelesenen Daten und der neuen Erzeugungsinformation in die ermittelte Seite (10a, ..., 10e) .

2. Speicher mit:
einer Mehrzahl von Seiten (10a, ..., 10e), die jeweils Speicherzellen zum Speichern von Daten und einer der Seite zugeordneten Erzeugungsinformation aufweisen; und
einer Vorrichtung nach Anspruch 1.

3. Verfahren zum Behandeln eines aus einem unvollständigen Schreiben oder Löschen von Daten resultierenden Zustands eines Speichers mit in einer Mehrzahl von Seiten (10a, ..., 10e) organisierten Speicherzellen, wobei jede Seite (10a, ..., 10e) eine Erzeugungsinformation aufweist, die auf einen Programmierzeitpunkt der Seite (10a, ..., 10e) hinweist, mit folgenden Schritten:
Ermitteln einer Erzeugungsinformation aus den Erzeugungsinformationen der Mehrzahl von Seiten (10a, ..., 10e), um eine ermittelte Erzeugungsinformation zu erhalten, wobei die ermittelte Erzeugungsinformation auf einen Programmierzeitpunkt der Mehrzahl von Seiten (10a, ..., 10e) hinweist, der nicht der älteste Programmierzeitpunkt der Programmierzeitpunkte der Mehrzahl von Seiten ist;
Ermitteln einer Seite (P_{b}) aus der Mehrzahl von Seiten (10a, ..., 10e), die eine Inkonsistenz umfaßt, um eine ermittelte Seite (P_{b}) zu erhalten, wobei die Inkonsistenz aus dem unvollständigen Schreiben oder Löschen von Daten resultiert;
Auswählen einer weiteren Seite (P_{g}) aus der Mehrzahl von Seiten (10a, ..., 10e), um eine ausgewählte Seite (P_{g}) zu erhalten;
Markieren (110) der weiteren Seite (P_{g}), um eine markierte Seite (P_{g}*) zu erhalten;
Bereitstellen neuer Erzeugungsinformation basierend auf der ermittelten Erzeugungsinformation;
Lesen (140) von Daten aus der markierten Seite (P_{g}*) ; und
Schreiben (140) der aus der markierten Seite (P_{g}*) gelesenen Daten und der neuen Erzeugungsinformation in die ermittelte Seite (P_{b}).

4. Verfahren nach Anspruch 3, bei dem die ermittelte Erzeugungsinformation auf den jüngsten Programmierzeitpunkt der Mehrzahl von Seiten (10a, ..., 10e) hinweist.

5. Verfahren nach Anspruch 3 oder 4, bei dem jede der Mehrzahl von Seiten (10a, ..., 10e) einen Adreßspeicherplatz (14) zum Speichern einer der Seite (10a, ..., 10e) zugeordneten Adresse von einer Mehrzahl von Adressen aufweist, wobei in einem Zustand des Speichers, der nicht von einem unvollständigen Schreiben oder Löschen herrührt, jede der Mehrzahl von Adressen nur einer der Mehrzahl von Seiten (10a, ..., 10e) zugeordnet ist, und bei dem der Schritt des Ermittelns einer Seite (P_{b}), die eine Inkonsistenz aufgrund eines unvollständigen Schreibens oder Löschens von Daten umfaßt, einen Schritt des Ermittelns einer Seite (P_{b}), deren Dateninhalt nicht mit ihrem Fehlerkorrekturcode übereinstimmt, oder deren zugeordnete Adresse ferner einer Seite (10a, ..., 10e) zugeordnet ist, deren Erzeugungsinformation auf einen späteren Programmierzeitpunkt hinweist, aufweist.

6. Verfahren nach einem der Ansprüche 3 bis 5, bei dem die Erzeugungsinformation jeder Seite (10a, ..., 10e) einen Zeitstempel umfaßt, wobei der Zeitstempel den Stand eines Schreibvorgangzählers zum Zählen von Schreibvorgängen zum Zeitpunkt des letzen vorangegangenen Schreibens der jeweiligen Seite (10a, ..., 10e) darstellt.

7. Verfahren nach einem der Ansprüche 3 bis 6, bei dem der Schritt des Markierens (110) der ausgewählten Seite (P_{g}) ein Setzen eines Markierungsbits, das der weiteren Seite (10a, ..., 10e) zugeordnet ist, umfaßt.

8. Verfahren nach einem der Ansprüche 3 bis 7, ferner mit folgendem Schritt:
Löschen (120) der ermittelten Seite (P_{b}) vor dem Schreiben der aus der markierten Seite (P_{g}*) gelesenen Daten und der neuen Erzeugungsinformation in die ermittelte Seite (P_{b}).

9. Verfahren nach Anspruch 8, ferner mit folgendem Schritt:
Markieren (130) der markierten Seite (P_{g}*), um eine zweifach markierte Seite (P_{g}**) zu erhalten, nach dem Löschen (120) der ermittelten Seite (P_{b}) und vor dem Schreiben (140).

10. Verfahren nach einem der Ansprüche 3 bis 9,
bei dem der Schritt des Lesens ein Kopieren der Daten von der markierten Seite (P_{g}*) in einen Zwischenspeicher umfaßt,
bei dem der Schritt des Bereitstellens der neuen Erzeugungsinformation ein Schreiben der neuen Erzeugungsinformation in den Zwischenspeicher umfaßt, und
bei dem der Schritt des Schreibens der aus der markierten Seite (P_{g}*) gelesenen Daten und der neuen Erzeugungsinformation einen Schritt des Kopierens derselben aus dem Zwischenspeicher in die ermittelte Seite (P_{b}) umfaßt.

11. Verfahren nach Anspruch 10, bei dem der Schritt des Kopierens (140) der Daten und der neuen Erzeugungsinformation ein paralleles Übertragen der Daten und der Erzeugungsinformation über eine Mehrzahl paralleler Leitungen umfaßt, wobei jedem Bit der Daten und der Erzeugungsinformation eine der Mehrzahl paralleler Leitungen zugeordnet ist.

12. Verfahren nach einem der Ansprüche 3 bis 11, ferner mit folgendem Schritt:
Löschen (150) der markierten Seite (P_{g}*; P_{g}**) nach dem Lesen der Daten aus der markierten Seite (P_{g}*; P_{g}**).

13. Verfahren nach einem der Ansprüche 3 bis 12, bei dem der Schritt des Auswählens der weiteren Seite (P_{g}*) einen Schritt des Auswählens derjenigen Seite (10a, ..., 10e) als die ausgewählte Seite (P_{g}*), deren Erzeugungsinformation auf den ältesten Programmierzeitpunkt der Mehrzahl von Seiten (10a, ..., 10e) hinweist, umfaßt.

14. Verfahren zum Behandeln eines aus einem unvollständigen Löschen einer Seite (P_{b}) eines Speichers resultierenden Zustands eines Speichers mit in einer Mehrzahl von Seiten (10a, ..., 10e) organisierten Speicherzellen, wobei jeder Seite (10a, ..., 10e) eine Erzeugungsinformation zugeordnet ist, die auf einen Programmierzeitpunkt der Seite (10a, ..., 10e) hinweist, und ein Markierungsbit aufweist, mit folgenden Schritten:
Bestimmen einer Seite (P_{g}*), deren Markierungsbit gesetzt ist;
Ermitteln von Erzeugungsinformationen aus den Erzeugungsinformationen der Mehrzahl von Seiten (10a, ..., 10e), um eine ermittelte Erzeugungsinformation zu erhalten, wobei die ermittelte Erzeugungsinformation auf einem Programmierzeitpunkt der Mehrzahl von Seiten hinweist, der nicht der älteste Programmierzeitpunkt der Programmierzeitpunkte der Mehrzahl von Seiten ist;
Ermitteln einer Seite (P_{b}), die eine Inkonsistenz umfaßt, um eine ermittelte Seite (P_{b}) zu erhalten, wobei die Inkonsistenz aus dem unvollständigen Löschen von Daten resultiert;
Bereitstellen von neuer Erzeugungsinformation basierend auf der ermittelten Erzeugungsinformation;
Löschen der Seite (P_{b}), die die Inkonsistenz umfaßt;
Lesen von Daten aus der markierten Seite (P_{g}*); und
Schreiben der aus der markierten Seite (P_{g}*) gelesenen Daten und der neuen Erzeugungsinformation in die ermittelte Seite (P_{g}), die die Inkonsistenz umfaßt.

15. Verfahren zum Behandeln eines aus einem unvollständigen Schreiben oder Löschen von Daten resultierenden Zustands eines Speichers mit in einer Mehrzahl von Seiten (10a, ..., 10e) organisierten Speicherzellen, wobei jede Seite eine Erzeugungsinformation aufweist, die auf einen Programmierzeitpunkt der Seite hinweist, und wobei jede Seite (10a, ..., 10e) ein erstes Markierungsbit und ein zweites Markierungsbit, das das unvollständige Schreiben oder Löschen anzeigt, aufweist, mit folgenden Schritten:
Ermitteln einer markierten Seite (P_{g}**), deren zweiten Markierungsbit gesetzt ist;
Ermitteln einer Erzeugungsinformation aus den Erzeugungsinformationen der Mehrzahl von Seiten (10a, ..., 10e), um eine ermittelte Erzeugungsinformation zu erhalten, wobei die ermittelte Erzeugungsinformation auf einem Programmierzeitpunkt der Mehrzahl von Seiten (10a, ..., 10e) hinweist, der nicht der älteste Programmierzeitpunkt der Programmierzeitpunkte der Mehrzahl von Seiten ist;
Ermitteln einer Seite (P_{b}), die eine Inkonsistenz umfaßt, um eine ermittelte Seite (P_{b}) zu erhalten, wobei die Inkonsistenz aus dem unvollständigen Schreiben oder Löschen von Daten resultiert;
Bereitstellen von neuer Erzeugungsinformation basierend auf der ermittelten Erzeugungsinformation;
Lesen (140) von Daten aus der markierten Seite (P_{g}**), deren zweites Markierungsbit gesetzt ist;
Schreiben (140) der aus der markierten Seite (P_{g}**), deren zweites Markierungsbit gesetzt ist, gelesenen Daten und der neuen Erzeugungsinformation in die ermittelte Seite (P_{b});
Setzen (140) des ersten Markierungsbits der ermittelten Seite (P_{b});
Bereitstellen von weiterer neuer Erzeugungsinformation basierend auf der neuen Erzeugungsinformation;
Lesen (140) von Daten aus der ermittelten Seite (P_{b}) nach dem Schreiben der aus der markierten Seite (P_{g}**), deren zweites Markierungsbit gesetzt ist, gelesenen Daten in die ermittelte Seite (P_{b}) und nach dem Setzen des ersten Markierungsbits;
Schreiben der aus der ermittelten Seite (P_{b}) gelesenen Daten und der weiteren neuen Erzeugungsinformation in die markierte Seite (P_{g}**), deren zweites Markierungsbit gesetzt ist.

16. Verfahren nach Anspruch 15, ferner mit folgendem Schritt:
Löschen (150) der markierten Seite (P_{g}**), deren zweites Markierungsbit gesetzt ist, nach dem Schreiben der aus der markierten Seite (P_{g}**), deren zweites Markierungsbit gesetzt ist, gelesenen Daten in die ermittelte Seite (P_{b}).

17. Verfahren nach Anspruch 15 oder 16, ferner mit folgendem Schritt:
Löschen der ermittelten Seite (P_{b}) nach dem Schreiben der aus der ermittelten Seite (P_{b}) gelesenen Daten in die markierte Seite (P_{g}**), deren zweites Markierungsbit gesetzt ist.

18. Computer-Programm mit Programmcode zur Durchführung eines Verfahren nach einem der Ansprüche 3 bis 17, wenn das Programm auf einem Computer abläuft.

## Claims

1. Apparatus for handling a state resulting from incomplete writing or erasing of data of a memory having memory cells organized in a plurality of pages (10a, ..., 10e), each of which having associated therewith generation information indicating a programming time of the page, comprising:
means (20) for determining generation information from the generation information of the plurality of pages (10a, ..., 10e) so as to obtain determined generation information, the determined generation information indicating a programming time of the plurality of pages (10a, ..., 10e) not being the oldest programming time of the programming times of the plurality of pages;
page determining means (24) for determining a page (P_{b}) from the plurality of pages (10a, ..., 10e) comprising an inconsistency due to incomplete writing or erasing of data so as to obtain a determined page (P_{b});
selection means (26) for selecting a further page (P_{g}) from the plurality of pages (10a, ..., 10e) so as to obtain a selected page (P_{g});
flagging means (30) for flagging the selected page (P_{g}) so as to obtain a flagged page (P_{g}*) ;
providing means (22) for providing new generation information based on the determined generation information;
reading means (28) for reading data from the flagged page (P_{g}*); and
writing means (30) for writing the data read from the flagged page (10a, ..., 10e) and the new generation information to the determined page (10a, ..., 10e).

2. Memory, comprising:
a plurality of pages (10a, ..., 10e) each comprising memory cells for storing data and generation information associated with the page; and
an apparatus according to claim 1.

3. Method of handling a state resulting from incomplete writing or erasing data of a memory having memory cells organized in a plurality of pages (10a, ..., 10e), each page (10a, ..., 10e) comprising generation information indicating a programming time of the page (10a, ..., 10e), comprising:
determining generation information from the generation information of the plurality of pages (10a, ..., 10e) so as to obtain determined generation information, the determined generation information indicating a programming time of the plurality of pages (10a, ..., 10e) not being the oldest programming time of the programming times of the plurality of pages;
determining a page (P_{b}) from the plurality of pages (10a, ..., 10e) comprising an inconsistency so as to obtain a determined page (P_{b}), the inconsistency resulting from the incomplete writing or erasing of data;
selecting a further page (P_{b}) from the plurality of pages (10a, ..., 10e) so as to obtain a selected page (P_{g});
flagging (110) the further page (P_{g}) so as to obtain a flagged page (P_{g}*);
providing new generation information based on the determined generation information;
reading (140) data from the flagged page (P_{g}*); and
writing (140) the data read from the flagged page (P_{g}*) and the new generation information to the determined page (P_{b}).

4. Method according to claim 3, wherein the determined generation information indicates the most recent programming time of the plurality of pages (10a, ..., 10e).

5. Method according to claims 3 or 4, wherein each of the plurality of pages (10a, ..., 10e) comprises an address memory location (14) for storing an address of a plurality of addresses associated with the page (10a, ..., 10e), wherein, in a state of the memory not originating from incomplete writing or erasing, each of the plurality of addresses is associated with only one of the plurality of pages (10a, ..., 10e), and wherein the step of the determining of a page (P_{b}) comprising an inconsistency due to incomplete writing or erasing of data comprises a step of determining a page (P_{b}) the data content of which does not match its error correction code or the associated address of which is further associated with a page (10a, ..., 10e) the generation information of which indicates a later programming time.

6. Method according to any one of claims 3 to 5, wherein the generation information of each page (10a, ..., 10e) comprises a time stamp, the time stamp representing the count of a write-operation counter for counting write operations at the time of the last preceding writing of the respective page (10a, ..., 10e).

7. Method according to any one of claims 3 to 6, wherein the step of the flagging (110) of the selected page (P_{g}) comprises setting a flag bit associated with the further page (10a, ..., 10e).

8. Method according to any one of claims 3 to 7, further comprising:
erasing (120) the determined page (P_{b}) prior to writing the data read from the flagged page (P_{g}*) and the new generation information to the determined page (P_{b}).

9. Method according to claim 8, further comprising:
flagging (130) the flagged page (P_{g}*) so as to obtain a double-flagged page (P_{g}**) so as to obtain a page flagged twice (P_{g}**), after the erasing (120) of the determined page (P_{b}) and prior to the writing (140).

10. Method according to any one of claims 3 to 9,
wherein the step of the reading comprises a copying of the data from the flagged page (P_{g}*) to a latch,
wherein the step of the providing of the new generation information comprises writing the new generation information to the latch, and
wherein the step of the writing of the data read from the flagged page (P_{g}*) and the new generation information comprises a step of copying same from the latch to the determined page (P_{b}).

11. Method according to claim 10, wherein the step of the copying (140) of the data and the new generation information comprises a parallel transferring of the data and the generation information via a plurality of parallel lines, wherein each bit of the data and of the generation information has associated therewith one of the plurality of parallel lines.

12. Method according to any one of claims 3 to 11, further comprising:
erasing (150) the flagged page (P_{g}*; P_{g}**) after the reading of the data from the flagged page (P_{g}*; P_{g}**).

13. Method according to any one of claims 3 to 12, wherein the step of the selecting of the further page (P_{g}*) comprises a step of selecting that page (10a, ..., 10e) as the selected page (P_{g}*) the generation information of which indicates the oldest programming time of the plurality of pages (10a, ..., 10e).

14. Method for handling a state of a memory resulting from incomplete erasing of a page (P_{b}) of a memory having memory cells organized in a plurality of pages (10a, ..., 10e), each page (10a, ..., 10e) having associated therewith generation information indicating a programming time of the page (10a, ..., 10e), and having a flag bit, comprising:
determining a page (P_{g}*) the flag bit of which is set;
determining generation information from the generation information of the plurality of pages (10a, ..., 10e) so as to obtain determined generation information, the determined generation information indicating a programming time of the plurality of pages not being the oldest programming time of the programming times of the plurality of pages;
determining a page (P_{b}) comprising an inconsistency so as to obtain a determined page (P_{b}), the inconsistency resulting from the incomplete erasing of data;
providing new generation information based on the determined generation information;
erasing the page (P_{b}) comprising the inconsistency;
reading data from the flagged page (P_{g}*); and
writing the data read from the flagged page (P_{g}*) and the new generation information to the determined page (P_{g}) comprising the inconsistency.

15. Method of handling a state resulting from incomplete writing or erasing of data of a memory having memory cells organized in a plurality of pages (10a, ..., 10e), each page comprising generation information indicating a programming time of the page, and each page (10a, ..., 10e) comprising a first flag bit and a second flag bit indicating the incomplete writing or erasing, comprising:
determining a flagged page (P_{g}**) the second flag bit of which is set;
determining generation information from the generation information of the plurality of pages (10a, ..., 10e) so as to obtain determined generation information, the determined generation information indicating a programming time of the plurality of pages (10a, ..., 10e) not being the oldest programming time of the programming times of the plurality of pages;
determining a page (P_{b}) comprising an inconsistency so as to obtain a determined page (P_{b}), the inconsistency resulting from the incomplete writing or erasing of data;
providing new generation information based on the determined generation information;
reading (140) of data from the flagged page (P_{g}**) the second flag bit of which is set;
writing (140) of the data read from the flagged page (P_{g}**) the second flag bit of which is set and the new generation information to the determined page (P_{b});
setting (140) the first flag bit of the determined page (P_{b});
providing further new generation information based on the new generation information;
reading (140) data from the determined page (P_{b}) after the writing of the data read from the flagged page (P_{g}**) the second flag bit of which is set to the determined page (P_{b}) and after the setting of the first flag bit;
writing the data read from the determined page (P_{b}) and the further new generation information to the flagged page (P_{g}**) the second flag bit of which is set.

16. Method according to claim 15, further comprising:
erasing (150) the flagged page (P_{g}**) the second flag bit of which is set after the writing of the data read from the flagged page (P_{g}**) the second flag bit of which is set to the determined page (P_{b}).

17. Method according to claim 15 or 16, further comprising:
erasing the determined page (P_{b}) after the writing of data read from the determined page (P_{b}) to the flagged page (P_{g}**) the second flag bit of which is set.

18. Computer program with a program code for performing a method according to any one of claims 3 to 17 when the program runs on a computer.

## Revendications

1. Dispositif pour traiter un état, résultant d'une écriture ou d'un effacement incomplet de données, d'une mémoire avec des cellules de mémoire organisées en une pluralité de pages (10a, ..., 10e) à chacune desquelles est associée une information de génération indiquant un moment de programmation de la page, avec:
un moyen (20) destiné à déterminer une information de génération parmi les informations de génération de la pluralité de pages (10a, ..., 10e), pour obtenir une information de génération déterminée, l'information de génération déterminée indiquant un moment de programmation de la pluralité de pages (10a, ..., 10e) qui n'est pas le moment de programmation le plus ancien des moments de programmation de la pluralité de pages;
un moyen de détermination de page (24) destiné à déterminer une page (P_{b}) parmi la pluralité de pages (10a, ..., 10e) qui comporte une incohérence par suite d'une écriture ou d'un effacement incomplet de données, pour obtenir une page déterminée (P_{b});
un moyen de sélection (26) destiné à sélectionner une autre page (P_{g}) parmi la pluralité de pages (10a, ..., 10e), pour obtenir une page sélectionnée (P_{g});
un moyen de repérage (30) destiné à repérer la page sélectionnée (P_{g}), pour obtenir une page repérée (P_{g}*);
un moyen de mise à disposition (22) destiné à mettre à disposition une nouvelle information de génération sur base de l'information de génération déterminée;
un moyen de lecture (28) destiné à lire des données de la page repérée (P_{g}*); et
un moyen d'écriture (30) destiné à écrire les données lues de la page repérée (10a, ..., 10e) et la nouvelle information de génération dans la page déterminée (10a, ..., 10e).

2. Mémoire, avec:
une pluralité de pages (10a, ..., 10e) présentant, chacune, des cellules de mémoire destinées à mémoriser des données et une information de génération associée à la page; et
un dispositif selon la revendication 1.

3. Procédé pour traiter un état, résultant d'une écriture ou d'un effacement incomplet de données, d'une mémoire avec des cellules de mémoire organisées en une pluralité de pages (10a, ..., 10e), chaque page présentant une information de génération indiquant un moment de programmation de la page (10a, ..., 10e), aux étapes suivantes consistant à:
déterminer une information de génération parmi les informations de génération de la pluralité de pages (10a, ..., 10e), pour obtenir une information de génération déterminée, l'information de génération déterminée indiquant un moment de programmation de la pluralité de pages (10a, ..., 10e) qui n'est pas le moment de programmation le plus ancien des moments de programmation de la pluralité de pages;
déterminer une page (P_{b}) parmi la pluralité de pages (10a, ..., 10e) qui comporte une incohérence, pour obtenir une page déterminée (P_{b}), l'incohérence résultant de l'écriture ou de l'effacement incomplet de données,
sélectionner une autre page (P_{g}) parmi la pluralité de pages (10a, ..., 10e), pour obtenir une page sélectionnée (P_{g});
repérer (110) l'autre page sélectionnée (P_{g}), pour obtenir une page repérée (P_{g}*);
mettre à disposition une nouvelle information de génération sur base de l'information de génération déterminée;
lire (140) des données de la page repérée (P_{g}*); et
écrire (140) les données lues de la page repérée (P_{g}*) et la nouvelle information de génération dans la page déterminée (P_{g}*).

4. Procédé selon la revendication 3, dans lequel l'information de génération déterminée indique le moment de programmation le plus récent de la pluralité de pages (10a, ..., 10e).

5. Procédé selon la revendication 3 ou 4, dans lequel chacune de la pluralité de pages (10a, ..., 10e) présente un emplacement d'adresse (14) destiné à mémoriser une adresse, parmi une pluralité d'adresses, associée à la page (10a, ..., 10e), chacune de la pluralité d'adresses n'étant, dans un état de la mémoire ne résultant pas d'une écriture ou d'un effacement incomplet, associée qu'à l'une de la pluralité de pages (10a, ..., 10e), et dans lequel l'étape consistant à déterminer une page (P_{b}) comportant une incohérence par suite d'une écriture ou d'un effacement incomplet de données présente une étape consistant à déterminer une page (P_{b}) dont le contenu de données ne coïncide pas avec son code de correction d'erreur ou dont l'adresse lui associée est par ailleurs associée à une page (10a, ..., 10e) dont l'information de génération indique un moment de programmation ultérieur.

6. Procédé selon l'une des revendications 3 à 5, dans lequel l'information de génération de chaque page (10a, ..., 10e) comprend une estampille, l'estampille représentant l'état d'un compteur d'opérations d'écriture destiné à compter les opérations d'écriture au moment de la dernière écriture précédente de la page respective (10a, ..., 10e).

7. Procédé selon l'une des revendications 3 à 6, dans lequel l'état consistant à repérer (110) la page sélectionnée (P_{g}) comprend le placement d'un bit de repérage associé à l'autre page (10a, ..., 10e).

8. Procédé selon l'une des revendications 3 à 7, par ailleurs avec l'étape suivante consistant à:
effacer (120) la page déterminée (P_{b}) avant l'écriture des données lues de la page repérée (P_{g}*) et de la nouvelle information de génération dans la page déterminée (P_{b}).

9. Procédé selon la revendication 8, par ailleurs avec l'étape suivante consistant à:
repérer (130) la page repérée (P_{g}*), pour obtenir une page repérée deux fois (P_{g}**), après l'effacement (120) de la page déterminée (P_{b}) et avant l'écriture (140).

10. Procédé selon l'une des revendications 3 à 9,
dans lequel l'étape consistant à lire comprend une copie des données de la page repérée (P_{g}*) dans une mémoire intermédiaire,
dans lequel l'étape consistant à mettre à disposition la nouvelle information de génération comprend une écriture de la nouvelle information de génération dans la mémoire intermédiaire, et
dans lequel l'étape consistant à écrire les données lues de la page repérée (P_{g}*) et de la nouvelle information de génération comprend une étape consistant à copier celles-ci de la mémoire intermédiaire dans la page déterminée (P_{b}).

11. Procédé selon la revendication 10, dans lequel l'étape consistant à copier (140) les données et la nouvelle information de génération comprend une transmission en parallèle des données et de la nouvelle information de génération via une pluralité de lignes parallèles, à chaque bit des données et de l'information de génération étant associée l'une de la pluralité des lignes parallèles.

12. Procédé selon l'une des revendications 3 à 11, par ailleurs avec l'étape suivante consistant à:
effacer (150) la page repérée (P_{g}*; P_{g}**) après la lecture des données de la page repérée (P_{g}*; P_{g}**).

13. Procédé selon l'une des revendications 3 à 12, dans lequel l'étape consistant à sélectionner l'autre page (P_{g}*) comprend une étape consistant à sélectionner comme page sélectionnée (P_{g}*) la page (10a, ..., 10e) dont l'information de génération indique le moment de programmation le plus ancien de la pluralité de pages (10a, ..., 10e).

14. Procédé pour traiter un état, résultant d'un effacement incomplet d'une page (P_{b}) d'une mémoire, d'une mémoire avec des cellules de mémoire organisées en une pluralité de pages (10a, ..., 10e), à chaque page étant associée une information de génération indiquant un moment de programmation de la page (10a, ..., 10e), et présentant un bit de repérage, aux étapes suivantes consistant à:
déterminer une page (P_{g}*) dont le bit de repérage est placé;
déterminer des informations de génération à partir des informations de génération de la pluralité de pages (10a, ..., 10e), pour obtenir une information de génération déterminée, l'information de génération déterminée indiquant un moment de programmation de la pluralité de pages qui n'est pas le moment de programmation le plus ancien des moments de programmation de la pluralité de pages;
déterminer une page (P_{b}) qui comporte un incohérence, pour obtenir une page déterminée (P_{b}), l'incohérence résultant de l'effacement incomplet de données;
mettre à disposition une nouvelle information de génération sur base de l'information de génération déterminée;
effacer la page (P_{b}) qui comporte l'incohérence;
lire des données de la page repérée (P_{g}*); et
écrire les données lues de la page repérée (P_{g}*) et la nouvelle information de génération dans la page déterminée (P_{g}) qui comporte l'incohérence.

15. Procédé pour traiter un état, résultant d'une écriture ou d'un effacement incomplet de données, d'une mémoire avec des cellules de mémoire organisées en une pluralité de pages (10a, ..., 10e), chaque page présentant une information de génération indiquant un moment de programmation de la page, et chaque page (10a, ..., 10e) présentant un premier bit de repérage et un deuxième bit de repérage indiquant l'écriture ou l'effacement incomplet, aux étapes suivantes consistant à:
déterminer une page repérée (P_{g}**) dont le deuxième bit de repérage est placé;
déterminer une information de génération à partir des informations de génération de la pluralité de pages (10a, ..., 10e), pour obtenir une information de génération déterminée, l'information de génération déterminée indiquant un moment de programmation de la pluralité de pages qui n'est pas le moment de programmation le plus ancien des moments de programmation de la pluralité de pages;
déterminer une page (P_{b}) qui comporte un incohérence, pour obtenir une page déterminée (P_{b}), l'incohérence résultant de l'écriture ou de l'effacement incomplet de données;
mettre à disposition une nouvelle information de génération sur base de l'information de génération déterminée;
lire (140) les données de la page repérée (P_{g}*) dont le deuxième bit de repérage est placé ;
écrire (140) les données lues de la page repérée (P_{g}**) dont le deuxième bit de repérage est placé et la nouvelle information de génération dans la page déterminée (P_{b});
placer (140) le premier bit de repérage de la page déterminée (P_{b});
mettre à disposition une autre nouvelle information de génération sur base de la nouvelle information de génération;
lire (140) des données de la page déterminée (P_{b}) après l'écriture dans la page déterminée (P_{b}) des données lues de la page repérée (P_{g}**) dont le deuxième bit de repérage est placé et après le placement du premier bit de repérage;
écrire les données lues de la page déterminée (P_{b}) et l'autre nouvelle information de génération dans la page repérée (P_{g}**) dont le deuxième bit de repérage est placé.

16. Procédé selon la revendication 15, par ailleurs avec l'étape suivante consistant à:
effacer (150) la page repérée (P_{g}**) dont le deuxième bit de repérage est placé après l'écriture des données lues de la page repérée (P_{g}**) dont le deuxième bit de repérage est placé dans la page déterminée (P_{b}).

17. Procédé selon la revendication 15 ou 16, par ailleurs avec l'étape suivante consistant à:
effacer la page déterminée (P_{b}) après l'écriture des données lues de la page déterminée (P_{b}) dans la page repérée (P_{g}**) dont le deuxième bit de repérage est placé.

18. Programme d'ordinateur à code de programme pour réaliser un procédé selon l'une des revendications 3 à 17 lorsque le programme est exécuté sur un ordinateur.
